(19)

Europäisches
Patentamt

European
Patent Office

Office européen
des brevets

(11) **EP 1 889 394 B1**

(12) **FASCICULE DE BREVET EUROPEEN**

(45) Date de publication et mention
de la délivrance du brevet:
**01.12.2010 Bulletin 2010/48**

(21) Numéro de dépôt: **06764720.6**

(22) Date de dépôt: **02.06.2006**

(51) Int Cl.:
**H04L 1/06** (2006.01)

(86) Numéro de dépôt international:
**PCT/FR2006/001252**

(87) Numéro de publication internationale:
**WO 2006/129021 (07.12.2006 Gazette 2006/49)**

(54) **PROCEDE ET SYSTEME DE CODAGE CONVOLUTIF POUR LA TRANSMISSION DE CODES SPATIO-TEMPORELS EN BLOCS SELON LA TECHNIQUE DITE GOLDEN CODE**

FALTUNGSCODIERUNGSVERFAHREN UND -SYSTEM ZUR BLOCKÜBERTRAGUNG VON RÄUMLICH-ZEITLCHEN CODES GEMÄSS DER SOGENANNTEN GOLDENEN CODETECHNIK

CONVOLUTIVE CODING METHOD AND SYSTEM FOR BLOCK TRANSMISSION OF SPATIO-TEMPORAL CODES IN ACCORDANCE WITH THE SO-CALLED GOLDEN CODE TECHNIQUE

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **03.06.2005 FR 0505662**

(43) Date de publication de la demande:
**20.02.2008 Bulletin 2008/08**

(73) Titulaire: **Comsis**
**75014 Paris (FR)**

(72) Inventeur: **CHAMPION, David**
**F-75014 Paris (FR)**

(74) Mandataire: **Pontet, Bernard et al**
**Pontet Allano & Associés s.e.l.a.r.l.**
**25, Rue Jean Rostand**
**Parc Club Orsay Université**
**91893 Orsay Cedex (FR)**

(56) Documents cités:
• **BELFIORE J-C ET AL: "The golden code: a 2 x 2 full-rate space-time code with non-vanishing determinants" INFORMATION THEORY, 2004. ISIT 2004. PROCEEDINGS. INTERNATIONAL SYMPOSIUM ON CHICAGO, ILLINOIS, USA JUNE 27-JULY 2, 2004, PISCATAWAY, NJ, USA,IEEE, 27 juin 2004 (2004-06-27), pages 310-310, XP010750021 ISBN: 0-7803-8280-3 cité dans la demande**
• **DAYAL P ET AL INSTITUTE OF ELECTRICAL AND ELECTRONICS ENGINEERS: "An optimal two transmit antenna space-time code and its stacked extensions" CONFERENCE RECORD OF THE 37TH. ASILOMAR CONFERENCE ON SIGNALS, SYSTEMS, & COMPUTERS. PACIFIC GROOVE, CA, NOV. 9 - 12, 2003, ASILOMAR CONFERENCE ON SIGNALS, SYSTEMS AND COMPUTERS, NEW YORK, NY : IEEE, US, vol. VOL. 1 OF 2. CONF. 37, 9 novembre 2003 (2003-11-09), pages 987-991, XP010701612 ISBN: 0-7803-8104-1**

**Description**

La présente invention se rapporte à un procédé de codage convolutif pour la transmission de codes spatio-temporels en blocs selon la technique dite Golden Code. Elle concerne également un système mettant en oeuvre un tel procédé.

D'une façon générale, l'invention s'applique au domaine de la transmission ou de la diffusion radio de données numériques, ou de données analogiques échantillonnées, notamment dans le cas de transmission avec les mobiles ou bien de façon plus générale, dans le cas de réseaux sans fil locaux ou non. L'invention peut notamment s'appliquer lorsqu'on désire faire des transmissions sans fils à grand débit. Une première catégorie d'application concerne les systèmes de communication cellulaire avec les mobiles tels que l'UMTS par exemple. Une seconde catégorie d'application concerne les réseaux locaux sans fils. Une troisième catégorie d'application est celle des futurs réseaux ad hoc.

D'une manière plus précise, la présente invention s'applique à des systèmes multi-antennes MIMO ("Multiple Input Multiple Output") mettant en oeuvre des codes spatio-temporels en blocs du type Golden Code.

Un Code Spatio-Temporel en Blocs (STBC pour *"Space Time Block Code"* en langue anglaise) est un ensemble fini $\Gamma$ de matrices complexes (les mots de code) ayant $M$ lignes et $T$ colonnes et dont chaque composante $\Gamma_{it}$ est le symbole qui sera transmis sur l'antenne $i$ $(1 \leq i \leq M)$ à l'instant $t$ $(1 \leq t \leq T)$. Un STBC est carré si $M = T$.

Les critères de construction d'un STBC tels que notamment définis dans le document V. Tarokh, N. Seshadri et A.R. Calderbank, « Space Time Codes for High Data Rates Wireless Communication : Performance Criterion and Code Construction » IEEE Transactions on Information Theory, vol. 44, no. 2, Mars 1998, sont les suivants :

- L'ordre de diversité (d'émission), noté $d$, d'un STBC est défini par :

$$d = \underset{\substack{X,Y \in \Gamma \\ X \neq Y}}{\text{Min}} \text{Rang}(X - Y)$$

Un STBC est de diversité pleine si l'ordre de diversité est maximal c'est-à-dire : $d = \text{Min } (M, T)$.

- Le gain de codage, noté $g$, d'un STBC de diversité pleine avec $T \geq M$ est défini par :

$$g = \underset{\substack{X,Y \in \Gamma \\ X \neq Y}}{\text{Min}} \sqrt[M]{Det((X - Y)(X - Y)^H)}$$

On démontre que la probabilité d'erreur moyenne par mot de code, sur un canal à évanouissement de Rayleigh, est proportionnelle à $1/(g \text{ RSB})^{d N}$ à fort Rapport Signal à Bruit. Pour maximiser les performances d'un STBC sur ce type de canal, il faut donc maximiser le gain de codage.

Comme indiqué précédemment, la présente invention concerne plus particulièrement un code spatio-temporel en blocs de type Golden Code

Le Golden Code, tel que défini dans le document J. C. Belfiore, G. Rekaya et E. Viterbo, « The Golden Code: A 2x2 Full-Rate Space-Time Code with Non-Vanishing Determinants," IEEE Transactions on Information Theory, vol. 44, no. 2, Avril 2005 est un STBC carré à 2 antennes d'émission (M=2 et T=2). Ce code est à diversité pleine (d=2). Il présente le meilleur gain de codage à l'heure actuelle. C'est la construction algébrique du Golden Code qui permet de réaliser son partitionnement.

Pour définir le Golden Code, il est nécessaire d'introduire l'algèbre cyclique de division (corps non commutatif), $A_Q$, construite sur le corps Q[i, θ] de la manière suivante :

$$A_Q = \left\{ \begin{bmatrix} a + b.\theta & c + d.\theta \\ i(c + d.\bar{\theta}) & a + b.\bar{\theta} \end{bmatrix} \text{ avec } a,b,c,d \in Q[i] \right\}$$

où $i^2 = -1$, $\theta = \dfrac{1+\sqrt{5}}{2}$ et $\overline{\theta} = \dfrac{1-\sqrt{5}}{2}$

On définit l'anneau, noté $A_z$, sur cette algèbre en restreignant a, b, c et d dans l'anneau des entiers de Gauss Z[i] :

$$A_z = \left\{ \begin{bmatrix} a+b.\theta & c+d.\theta \\ i(c+d.\overline{\theta}) & a+b.\overline{\theta} \end{bmatrix} \text{avec } a,b,c,d \in Z[i] \right\}$$

Le Golden Code infini, noté $\Gamma_\infty$, est un idéal principal de l'anneau $A_z$ généré par un élément $\alpha$ de cet anneau. Il est à noter que lorsque l'on opte pour une représentation vectorielle au lieu de matricielle, $A_z$ et par voie de conséquence le Golden Code sont des lattices de dimension réelle 8. L'élément $\alpha$ a été choisi de telle sorte que l'idéal forme un lattice correspondant $\sqrt{5}Z^8$. à C'est pourquoi le Golden Code inclut une normalisation par $1/\sqrt{5}$. Ainsi, on a :

$$\Gamma_\infty = \left\{ \frac{1}{\sqrt{5}} \alpha \begin{bmatrix} a+b.\theta & c+d.\theta \\ i(c+d.\overline{\theta}) & a+b.\overline{\theta} \end{bmatrix} \text{avec } a,b,c,d \in Z[i] \right\}$$

où

$$\alpha = \begin{bmatrix} 1+i-i.\theta & 0 \\ 0 & 1+i-i.\overline{\theta} \end{bmatrix}$$

On démontre que le gain de codage du Golden Code infini est de $1/\sqrt{5}$. Lorsque l'on utilise un code fini, il suffit de contraindre a, b, c et d à appartenir à un sous ensemble fini inclus dans Z[i] (une constellation QAM par exemple). Le fait que le Golden Code infini corresponde à $Z^8$ facilite grandement l'étiquetage binaire et le "shaping" (le fait d'extraire une constellation) tout en garantissant une bonne distance euclidienne entre les mots de code.

La présente invention a pour but un nouveau procédé pour améliorer le gain de codage d'un code spatio-temporel en blocs de type Golden Code.

Un autre but de l'invention est un système de codage de l'information particulièrement efficace dans le cas d'un canal à évanouissements ("fading channel" en langue anglaise).

On atteint au moins l'un des objectifs précités avec un procédé de codage convolutif pour la transmission de codes spatio-temporels en blocs selon la technique dite Golden Code, dans un réseau de communication sans fil comportant au moins une pluralité d'antennes à l'émission. Selon l'invention, le codage Golden Code est associé à une modulation codée en treillis TCM. Par ailleurs, on réalise le partitionnement nécessaire audit treillis de telle sorte que pour chaque étape de partitionnement, on multiplie un ensemble $\Gamma_\infty$ par au moins un élément de l'ensemble $B_k$ ($k \geq 1$) d'éléments de Az tels que :

$$B_k = \left\{ X \in Az \text{ et } |\text{Det}(X)|^2 = 2^k \right\},$$

l'ensemble $\Gamma_\infty$ dit "Golden Code infini", étant un idéal principal de l'anneau Az tel que défini par la technique Golden Code.

Avec la présente invention, on utilise donc avantageusement une technique de modulation codée avec le Golden Code, et on utilise la technique de partitionnement du Golden Code pour obtenir du gain de codage.

D'une façon générale, le gain de codage d'une séquence de mots de code STBC peut être définie de la manière qui suit.

Considérons une séquence $(X_k)_{1 \leq k \leq n}$ de n mots du code STBC $\Gamma$ (M=2, et T>1) émis l'un à la suite de l'autre.

Il est toujours possible de considérer cette séquence comme un unique mot de code d'un code STBC (M=2 et nT) constitué par la concaténation des n matrices $X_k$. Dans ce cas, on peut calculer un gain de codage, noté $g_n$, pour une séquence de longueur n :

$$g_n = \underset{\substack{(X_k) \neq (Y_k) \\ (X_k),(Y_k) \in \Gamma^n}}{Min} \sqrt[2]{Det\left(\sum_{k=1}^{n}(X_k - Y_k)(X_k - Y_k)^H\right)}$$

En posant $Z_k = X_k - Y_k$ et en modifiant l'indexation sur $Z_k$ de telle sorte que les $n_0$ premiers $Z_k$ soient tous non nuls et tous les autres nuls, on obtient :

$$Det\left(\sum_{k=1}^{n}(X_k - Y_k)(X_k - Y_k)^H\right) = Det\left(\sum_{k=1}^{n_0}Z_k Z_k^H\right)$$

Si l'on suppose que le STBC $\Gamma$ est de diversité maximale et de plus carré (comme c'est le cas du Golden Code), si $Z_k$ est non nul alors $Z_k$ est inversible et l'on peut définir $\widetilde{Z}_k = Det(Z_k)Z_k^{-1}$. On démontre alors aisément que :

$$Det\left(\sum_{k=1}^{n_0}Z_k Z_k^H\right) = \sum_{k=1}^{n_0}Det(Z_k Z_k^H) + \sum_{k=1}^{n_0}\sum_{j=k+1}^{n_0}\left\|\widetilde{Z}_k Z_j\right\|_2^2$$

où $\|X\|_2$ désigne la norme de Frobénius (ou norme 2) de la matrice X.

Si le code STBC considéré a une structure de groupe additif (comme Je Golden Code infini), on peut réécrire le gain de codage de la manière suivante :

$$g_n = \underset{1 \leq n_0 \leq n}{Min} \underset{\substack{Z_k \in \Gamma \\ Z_k \neq 0}}{Min} \sqrt[2]{\sum_{k=1}^{n_0}Det(Z_k Z_k^H) + \sum_{k=1}^{n_0}\sum_{j=k+1}^{n_0}\left\|\widetilde{Z}_k Z_j\right\|_2^2}$$

L'idée des modulations codées est de créer un lien temporel entre les différents mots de code STBC émis lors d'une séquence de manière à augmenter le gain de codage, ceci correspond au cas où $n_0 > 2$. Dans ce cas, on s'intéresse particulièrement aux termes croisés $\left\|\widetilde{Z}_k Z_j\right\|_2^2$ susceptibles d'augmenter considérablement le gain. Pour le cas $n_0=1$, on s'assure que les séquences de mots de codes qui n'ont qu'un seul mot de code non nul, disons $Z_k$, soient telles que $Det(Z_k Z_k^H)$ soit suffisamment élevé pour ne pas pénaliser le gain de codage global.

Pour ce faire, on utilise avantageusement la technique de modulation codée en treillis TCM (pour "Treillis Coded Modulation" en langue anglaise). Tout comme dans le cas d'un canal gaussien noté AWGN, il faut disposer d'un étiquetage binaire qui s'appuie sur un partitionnement de la constellation émise.

Dans le contexte des TCM, un partitionnement consiste à trouver à partir d'un groupe additif de départ $E_0$ une suite décroissante $(E_i)$ de sous groupe telle que à chaque étape de partition l'ensemble quotient $E_i/E_{i+1}$ ait un cardinal (on parlera d'ordre) qui soit une puissance de 2 pour permettre un étiquetage binaire.

Un bon partitionnement au sens des TCM doit permettre d'augmenter au fur et à mesure un critère de distance au sein de tous les sous ensembles. Dans le cas des TCM sur canal gaussien, il s'agit d'un critère de distance euclidienne au carré minimale alors que pour un STBC il s'agit du gain de codage :

$$g(E_i) = \underset{\substack{X \in E_i \\ X \neq 0}}{Min}\ Det(XX^H)$$

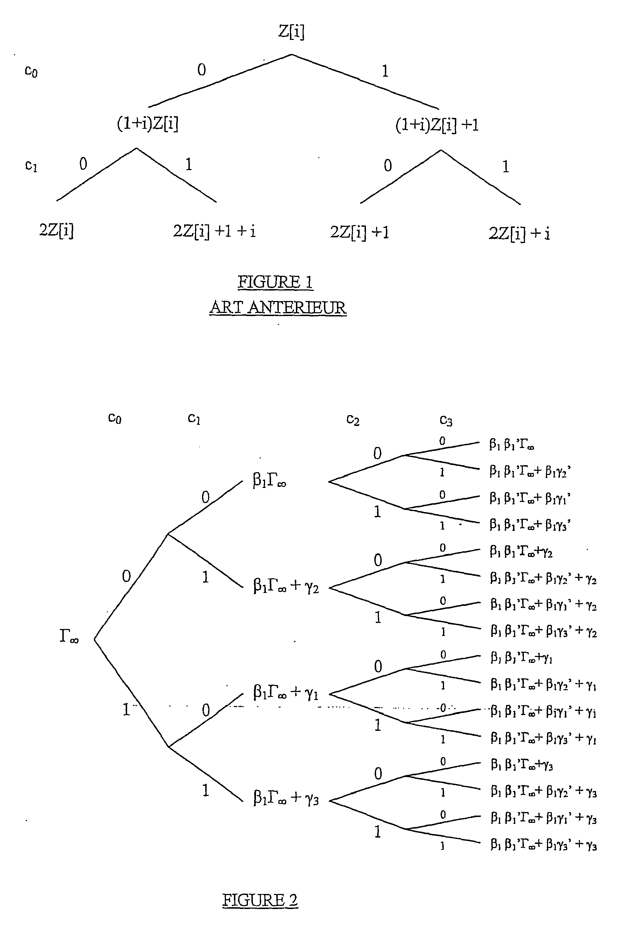

A titre d'exemple, toujours dans le cadre des TCM selon l'art antérieur, la figure 1 décrit une chaîne de partition de Z[i] (correspondant à une constellation QAM) dans le cas du canal gaussien (AWGN).

Cette chaîne de partition peut être continuée aussi longtemps que cela est nécessaire pour étiqueter un point d'une constellation QAM grâce aux bits $c_0$, $c_1$, ... . Il est important de noter qu'à chaque niveau de partition la distance euclidienne au carré au sein de chaque sous-ensemble est le double de celle du niveau précédent. De plus, on remarque que l'étiquetage binaire a été rendu possible grâce au fait que chaque ensemble se subdivise en n sous-ensembles (l'ordre) avec n une puissance de 2.

La présente invention s'applique particulièrement à des ensembles idéaux du Golden Code, ces ensembles étant définis de la manière qui suit.

Soit $\beta$ un élément de $A_z$ non nul et tel que $|Det(\beta)|^2 > 1$, on définit l'idéal principal à gauche de $\Gamma_\infty$ généré par $\beta$, noté $\beta.\Gamma_\infty$, et l'idéal principal à droite de $\Gamma_\infty$ généré par $\beta$, noté $\Gamma_\infty.\beta$, par :

$$\beta\Gamma_\infty = \left\{\beta X \big| X \in \Gamma_\infty\right\}$$

$$\Gamma_\infty\beta = \left\{X\beta \big| X \in \Gamma_\infty\right\}$$

Les idéaux à gauche et à droite peuvent être distincts en raison de la non commutativité de l'algèbre.

Il est facile de démontrer que ces deux idéaux principaux sont des sous groupes additifs (ou sous lattices) de $\Gamma_\infty$, qui présentent les deux propriétés suivantes :

- Le gain de codage de chacun des idéaux vaut :

$$g(\beta\Gamma_\infty) = g(\Gamma_\infty\beta) = \left|Det(\beta)\right| g(\Gamma_\infty) = \frac{\left|Det(\beta)\right|}{\sqrt{5}}$$

- Ces idéaux sont d'ordre $|Det(\beta)|^4$ par rapport à $\Gamma_\infty$, c'est-à-dire :

$$Card\left(\Gamma_\infty / \beta\Gamma_\infty\right) = Card\left(\Gamma_\infty / \Gamma_\infty\beta\right) = \left|Det(\beta)\right|^4$$

Avantageusement, dans la présente invention, on réalise un partitionnement du Golden Code adapté aux modulations codées

Comme cela a été mentionné précédemment, pour utiliser des TCM, il est nécessaire de créer un partitionnement où à chaque étape de la partition, un ensemble se subdivise en une puissance de 2 sous ensembles.

Comme $\beta$ est un élément de $A_z$, le déterminant de $\beta$ est dans Z[i]. On en déduit qu'il n'existe aucun $\beta$ tel que les idéaux principaux générés par $\beta$ soit d'ordre 2 par rapport à $\Gamma_\infty$ (ou d'ordre une puissance impaire de 2).

L'invention est notamment remarquable par le fait qu'on définit des $\beta$ pour lesquels l'ordre est une puissance de 4. On introduit alors avantageusement les ensembles $B_k$ ($k \geq 1$) d'éléments de $A_z$ tels que leur déterminant ait pour module carré $2^k$ :

$$B_k = \left\{X \in A_z \text{ et } \left|Det(X)\right|^2 = 2^k\right\}$$

Aucun des $B_k$ n'est vide car $\begin{bmatrix} i(1-\theta) & 1-\theta \cdot \\ i(1-\overline{\theta}) & i(1-\overline{\theta}) \end{bmatrix}^k$ appartient à $B_k$. Il est à noter d'ailleurs que tous les ensembles $B_k$ sont infinis.

Soit $\beta_k$ un élément quelconque de $B_k$, l'idéal $\beta_k \Gamma_\infty$ (ou l'idéal $\Gamma_\infty \beta_k$) constitue un sous lattice d'ordre $4^k$ de $\Gamma_\infty$ et de gain de codage de $\sqrt{2^k / 5}$. Ainsi, chacun des éléments de l'ensemble $\Gamma_\infty / \beta_k \Gamma_\infty$ peut être indexé par 2k bits. Grâce à ce procédé, on a effectué une première étape de partition qu'il suffit de réitérer pour obtenir autant de partitions que nécessaires.

Selon l'invention, $\beta$ peut être multiplié à $\Gamma_\infty$ par la gauche ou par la droite.

Selon une caractéristique préférée de l'invention, on considère :

$$\beta = \begin{bmatrix} i(1-\theta) & i(2-\theta) \\ -(2-\overline{\theta}) & i(1-\overline{\theta}) \end{bmatrix},$$

$\beta$ est un élément de $B_1$.

Selon une autre caractéristique de l'invention, on peut aussi multiplier l'ensemble $\Gamma_\infty$ par un élément $\beta'$ tel que :

$$\beta' = \begin{bmatrix} i\theta & -(1-\theta) \\ -i(1-\overline{\theta}) & i\overline{\theta} \end{bmatrix},$$

$\beta'$ est un élément de $B_1$.

Selon un mode réalisation avantageuse de l'invention, avec k=1, on réalise un partitionnement en quatre étapes, on utilise huit bits $c_0$ à $c_7$ pour réaliser le codage convolutif, et on code ces bits de codage convolutif à partir de quatre bits d'information $b_0$ à $b_3$ de telle sorte que :

$$c_0 = c_1 = c_2 = 0$$

$$c_3 = x\, b_0 + x^2 b_1 + x^3 b_2 + x^4 b_3$$

$c_4$, $c_5$, $c_6$ et $c_7$ étant respectivement égal à l'un des bits $b_0$ à $b_3$.

Suivant un autre aspect de l'invention, il est proposé un système de codage convolutif pour la transmission de codes spatio-temporels en blocs selon la technique dite Golden Code, dans un réseau de communication sans fil comportant au moins une pluralité d'antennes à l'émission. Selon l'invention, le système comprend un codeur convolutif recevant des bits d'information à transmettre et générant un ensemble de bits codés, un codeur spatio-temporel en blocs de type Golden Code, ces deux codeurs étant implémentés de sorte que le codeur spatio-temporel en blocs de type Golden Code transmet des séquences obéissant aux conditions suivantes : un codage convolutif par modulation codée en treillis TCM, et un partitionnement nécessaire audit treillis tel que pour chaque étape de partitionnement, on multiplie un ensemble $\Gamma_\infty$ par au moins un élément $\beta$ de l'ensemble $B_k$ (k≥1) d'éléments de Az tels que :

$$B_k = \{\, X \in Az \text{ et } |\text{Det}(X)|^2 = 2^k \},$$

l'ensemble $\Gamma_\infty$ dit "Golden Code infini", étant un idéal principal de l'anneau Az tel que défini par la technique Golden Code.

D'autres avantages et caractéristiques de l'invention apparaîtront à l'examen de la description détaillée d'un mode de mise en oeuvre nullement limitatif, et des dessins annexés, sur lesquels :

- La figure 1 décrit un partitionnement selon l'art antérieur;
- La figure 2 décrit un partitionnement en deux étapes selon la présente invention;
- La figure 3 est une représentation compacte du partitionnement de la figure 2;
- La figure 4 est une représentation compacte d'un exemple de partitionnement en quatre étapes selon l'invention;
- La figure 5 illustre un exemple de treillis pour la mise en oeuvre du procédé selon la présente invention;
- La figure 6 est une représentation graphique comparative entre un Golden Code non codé et un Golden Code codé par modulation; et
- La figure 7 est une vue schématique d'un système émetteur selon l'invention.

On va maintenant décrire des exemples de mise en oeuvre du procédé selon la présente invention afin d'obtenir un gain de codage en utilisant une technique de modulation codée avec un code spatio-temporel en blocs à deux antennes d'émission.

Sur la figure 2, on voit un partitionnement selon la présente invention. On considère deux éléments quelconques $\beta_1$ et $\beta_1$' de $B_1$, on peut créer un partitionnement en 16 de $\Gamma_\infty$ en deux étapes de partition. $B_1 = \{ X \in Az$ et $|Det(X)|^2 = 2\}$,

En notant les 4 éléments de l'ensemble $\Gamma_\infty / \beta_1\Gamma_\infty$ (resp. $\Gamma_\infty / \beta_1'\Gamma_\infty$) 0, $\gamma_1$, $\gamma_2$ et $\gamma_3$ (resp. 0, $\gamma_1'$, $\gamma_2'$ et $\gamma_3'$) qui seront indexés par le doublet de bits ($c_0$, $c_1$) (resp. ($c_2$, $c_3$)), le partitionnement peut être représenté comme illustré sur la figure 2. On démarre avec $\Gamma_\infty$. La première partition permet de générer quatre éléments en multipliant $\beta_1$ à gauche de $\Gamma_\infty$. On obtient alors, $\beta_1\Gamma_\infty$, $\beta_1\Gamma_\infty + \gamma_2$, $\beta_1\Gamma_\infty + \gamma_1$, et $\beta_1\Gamma_\infty + \gamma_3$. Ces quatre éléments sont codés avec deux bits de codage convolutif $c_0$ et $c_1$.

La seconde partition consiste à introduire $\beta'_1$ à gauche de $\Gamma_\infty$ et à générer seize éléments suivants : [$\beta_1 \beta_1'\Gamma_\infty$, $\beta_1 \beta_1'\Gamma_\infty + \beta_1\gamma_2'$, $\beta_1 \beta_1'\Gamma_\infty + \beta_1\gamma_1'$, $\beta_1 \beta_1'\Gamma_\infty + \beta_1\gamma_3'$]; [ $\beta_1 \beta_1'\Gamma_\infty + \gamma_2$, $\beta_1 \beta_1'\Gamma_\infty + \beta_1\gamma_2' + \gamma_2$, $\beta_1 \beta_1'\Gamma_\infty + \beta_1\gamma_1' + \gamma_2$, $\beta_1 \beta_1'\Gamma_\infty + \beta_1\gamma_3' + \gamma_2$]; [ $\beta_1 \beta_1'\Gamma_\infty + \gamma_1$, $\beta_1 \beta_1'\Gamma_\infty + \beta_1\gamma_2' + \gamma_1$, $\beta_1 \beta_1'\Gamma_\infty + \beta_1\gamma_1' + \gamma_1$, $\beta_1 \beta_1'\Gamma_\infty + \beta_1\gamma_3' + \gamma_1$]; [ $\beta_1 \beta_1'\Gamma_\infty + \gamma_3$, $\beta_1 \beta_1'\Gamma_\infty + \beta_1\gamma_2' + \gamma_3$, $\beta_1 \beta_1'\Gamma_\infty + \beta_1\gamma_1' + \gamma_3$, $\beta_1 \beta_1'\Gamma_\infty + \beta_1\gamma_3' + \gamma_3$]. Ces seize éléments sont codés avec deux bits de codage convolutif $c_2$ et $c_3$ en combinaison avec les bits $c_0$ et $c_1$.

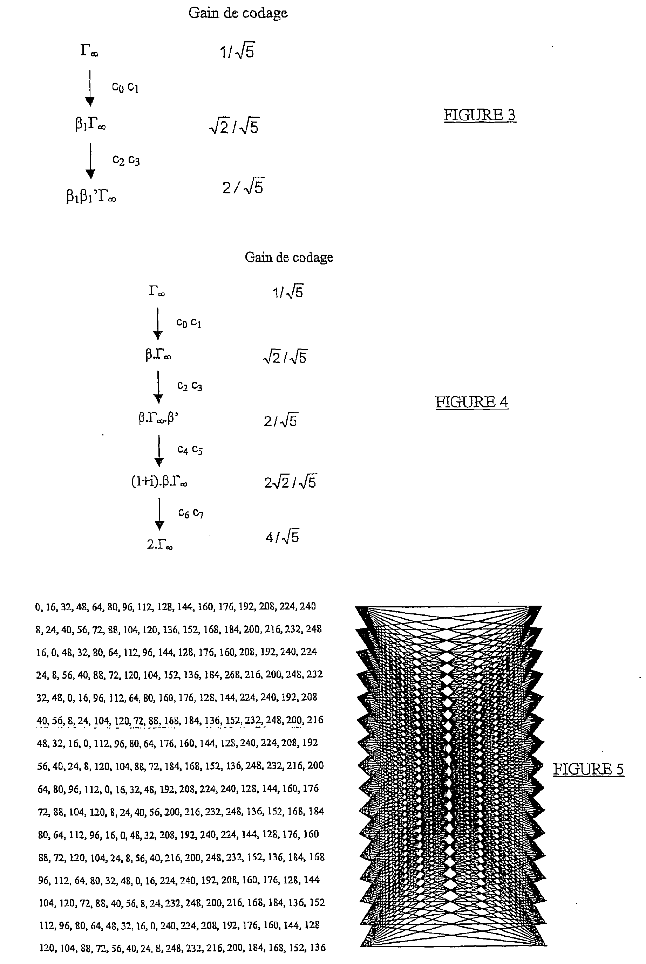

Ce partitionnement peut être représenté de manière plus compacte comme illustré sur la figure 3. Les gains de codage sont représentés à droite de chaque partition. Par principe du Golden Code, le gain est de $1/\sqrt{5}$ pour $\Gamma_\infty$.

La première partition présente un gain de codage de $\sqrt{2}/\sqrt{5}$. La troisième partition présente un gain de codage de $2/\sqrt{5}$. Le gain a donc été multiplié par deux avec une complexité limitée.

Ainsi, en utilisant des générateurs dans $B_1$, il est garanti de multiplier le gain de codage par un facteur $\sqrt{2}$ (1,5 dB) tous les 2 bits de partitions.

Le choix des éléments de $B_1$ utilisés et le choix de placer l'idéal à gauche ou à droite n'interviennent pas sur les gains de codage tout au long du partitionnement. Par contre, ces choix influencent le gain dans les termes croisés lorsque $n_0 > 1$ et le critère de distance euclidienne (au cas où le code serait utilisé sur un canal gaussien). On va maintenant décrire un exemple complet de construction d'une modulation codée en treillis appliquée à un Golden Code.

En choisissant $\beta = \begin{bmatrix} i(1-\theta) & i(2-\theta) \\ -(2-\overline{\theta}) & i(1-\overline{\theta}) \end{bmatrix}$ et $\beta' = \begin{bmatrix} i\theta & -(1-\theta) \\ -i(1-\overline{\theta}) & i\overline{\theta} \end{bmatrix}$ ($\beta$ et $\beta'$ sont des éléments de $B_1$), on construit un partitionnement en 4 étapes du Golden Code tel qu'illustré sur la figure 4.

Si toute séquence ($Z_k$) non nulle vérifie les conditions suivantes :

- $n_0 = 1$, alors le seul mot de code non nul émis appartient à $2.\Gamma_\infty$.
- $n_0 > 1$, alors au moins un des mots de code noté $Z_1$ appartient à $\beta.\Gamma_\infty$ et l'autre noté $Z_2$ appartient à $\beta.\Gamma_\infty.\beta'$.

Alors, on démontre que le gain de codage est de 4 (6 dB) par rapport au Golden Code.

Pour construire une séquence qui vérifie les conditions précédemment énoncées, on utilise un codage des bits $c_0$, $c_1$, ..., $c_7$ grâce à un codage convolutif que l'on décrit par un treillis (les autres bits dont le nombre dépend de la constellation QAM choisie étant non codés). Il existe de nombreux treillis permettant de construire une séquence vérifiant ces conditions. En particulier le nombre de transitions par état du treillis, qui va déterminer le rendement du code, va influer considérablement sur la complexité du treillis.

On décrit ici une solution introduisant un treillis assez peu complexe à 16 états et 16 transitions par état. Ainsi, il s'agit d'un code de rendement ½.

La figure 5 présente un tel treillis. Pour chaque état, les transitions qui correspondent à la séquence de bits $c_0$, $c_1$, ..., $c_7$ représentée sous forme d'un entier de 0 à 255 ($c_0$ étant le bit de poids faible) sont énumérées de haut en bas.

En réalité, les bits $c_0$, $c_1$ et $c_2$ sont fixés à 0. En notant les 4 bits d'information $b_0$, .., $b_3$, on peut donner une version systématique du codeur convolutif sous la forme :

$$c_0 = c_1 = c_2 = 0$$

$$c_3 = x\, b_0 + x^2 b_1 + x^3 b_2 + x^4 b_3$$

$$c_4 = b_0$$

$$c_5 = b_1$$

$$c_6 = b_2$$

$$c_7 = b_3$$

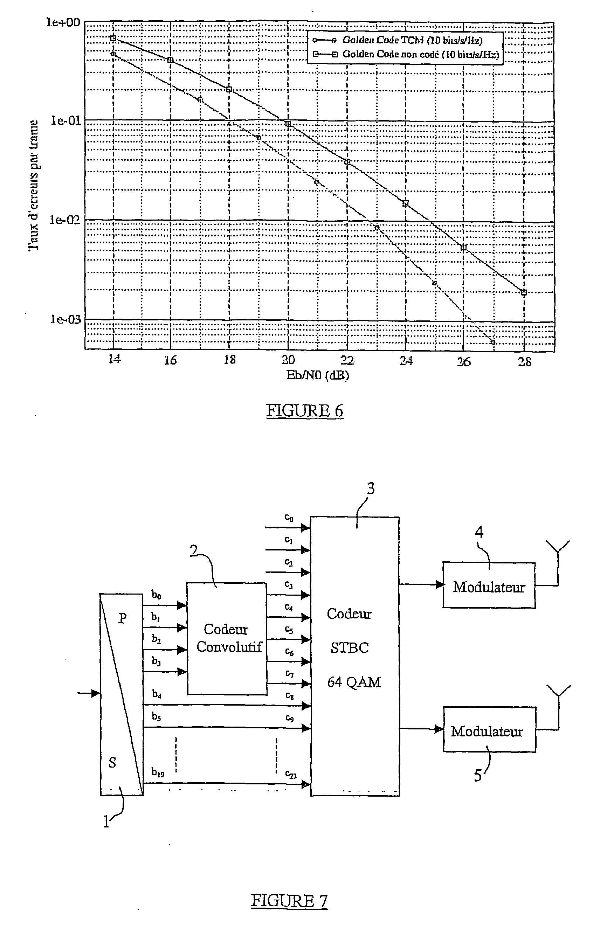

Etant donné que 4 bits de redondance sont introduits par le codage convolutif, le gain de performance est de 3 dB entre un Golden code non codé et ce Golden Code codé par modulation lorsque la comparaison est effectuée à efficacité spectrale égale conformément à la figure 6.

On va maintenant décrire en rapport avec la figure 7, un exemple d'implémentation d'un émetteur selon l'invention. On considère un Golden Code avec des symboles 64 QAM. Un mot de code STBC étant constitué de 4 symboles 64 QAM, il est étiqueté sur 24 bits : $c_0$, $c_1$, ..., $c_{23}$. Les bits $c_0$, ..., $c_7$ sont des bits codés par le code convolutif selon l'invention à partir de 4 bits d'information $b_0$, .., $b_3$. Les bits $c_8$, ..., $c_{23}$ sont eux directement des bits d'information. Le convertisseur série-parallèle 1 transmet les bits d'information $b_0$, .., $b_3$ vers le codeur convolutif 2 selon l'invention, et les bits d'information $b_4$, .., $b_{19}$ directement vers le codeur STBC-Golden Code 3.

Le codeur STBC 3 fournit aux deux modulateurs 4 et 5 un mot de code du Golden Code 64 QAM à partir des bits $c_0$, $c_1$, ..., $c_{23}$ en respectant l'étiquetage binaire défini par le partitionnement du code. Il est à noter que le partitionnement n'a pas forcément à être prolongé jusqu'à $c_{23}$ puisqu'à partir de $c_8$ on peut utiliser l'étiquetage classique sur une 16 QAM.

Bien sûr, l'invention n'est pas limitée aux exemples qui viennent d'être décrits et de nombreux aménagements peuvent être apportés à ces exemples sans sortir du cadre de l'invention.

**Revendications**

1. Procédé de codage convolutif pour la transmission de codes spatio-temporels en blocs selon la technique dite Golden Code, dans un réseau de communication sans fil comportant au moins une pluralité d'antennes à l'émission, **caractérisé en ce que** le codage Golden Code est associé à une modulation codée en treillis TCM, et **en ce qu'**on réalise le partitionnement nécessaire audit treillis de telle sorte que pour chaque étape de partitionnement, on multiplie un ensemble $\Gamma_\infty$ par au moins un élément $\beta$ de l'ensemble $B_k$ ($k \geq 1$) d'éléments de l'anneau Az tels que :

$$B_k = \{\ X \in Az \text{ et } |Det(X)|^2 = 2^k\},$$

l'ensemble $\Gamma_\infty$ dit "Golden Code infini", étant un idéal principal de l'anneau Az tel que défini par la technique Golden Code.

2. Procédé selon la revendication 1, **caractérisé en ce qu'**on multiplie $\beta$ à gauche de $\Gamma_\infty$.

3. Procédé selon la revendication 1, **caractérisé en ce qu'**on multiplie $\beta$ à droite de $\Gamma_\infty$.

4. Procédé selon l'une quelconque des revendications précédentes, **caractérisé en ce que** chaque composante d'une partition ainsi créée est indexée par 2k bits de codage convolutif.

5. Procédé selon l'une quelconque des revendications 1 à 4, **caractérisé en ce qu'**on considère :

$$\beta = \begin{bmatrix} i(1-\theta) & i(2-\theta) \\ -(2-\overline{\theta}) & i(1-\overline{\theta}) \end{bmatrix},$$

$\beta$ est un élément de $B_1$, $\theta = \dfrac{1+\sqrt{5}}{2}$ et $\overline{\theta} = \dfrac{1-\sqrt{5}}{2}$.

6. Procédé selon l'une quelconque des revendications 1 à 4, **caractérisé en ce qu'**on multiplie l'ensemble $\Gamma_\infty$ par un élément $\beta'$ tel que :

$$\beta' = \begin{bmatrix} i\theta & -(1-\theta) \\ -i(1-\overline{\theta}) & i\overline{\theta} \end{bmatrix},$$

$\beta'$ est un élément de $B_1$.

7. Procédé selon l'une quelconque des revendications précédentes, avec k=1, **caractérisé en ce qu'**on réalise un partitionnement en quatre étapes, on utilise huit bits $c_0$ à $c_7$ pour réaliser le codage convolutif, et on code ces bits de codage convolutif à partir de quatre bits d'information $b_0$ à $b_3$ de telle sorte que :

$$c_0 = c_1 = c_2 = 0$$

$$c_3 = x\, b_0 + x^2 b_1 + x^3 b_2 + x^4 b_3$$

$c_4$, $c_5$, $c_6$ et $c_7$ étant respectivement égal à l'un des bits $b_0$ à $b_3$.

8. Système de codage convolutif pour la mise en oeuvre d'un procédé selon l'une quelconque des revendications précédentes, pour la transmission de codes spatio-temporels en blocs selon la technique dite Golden Code, dans un réseau de communication sans fil comportant au moins une pluralité d'antennes à l'émission; **caractérisé en ce qu'**il comprend un codeur convolutif (2) recevant des bits d'information à transmettre et générant un ensemble de bits codés, un codeur spatio-temporel en blocs de type Golden Code (3), ces deux codeurs étant implémentés de sorte que le codeur spatio-temporel en blocs de type Golden Code transmet des séquences obéissant aux conditions suivantes : un codage convolutif par modulation codée en treillis TCM, et un partitionnement nécessaire audit treillis tel que pour chaque étape de partitionnement, on multiplie un ensemble $\Gamma_\infty$ par au moins un élément $\beta$ de l'ensemble $B_k$ (k≥1) d'éléments de l'anneau Az tels que :

$$B_k = \{\, X \in Az \text{ et } |Det(X)|^2 = 2^k \},$$

l'ensemble $\Gamma_\infty$ dit "Golden Code infini", étant un idéal principal de l'anneau Az tel que défini par la technique Golden Code.

**Claims**

1. Method of convolutive coding for the transmission of space-time block codes according to the technique termed Golden Code, in a wireless communication network comprising at least a plurality of transmit antennas, **characterized in that** the Golden Code coding is associated with a trellis coded modulation TCM, and **in that** the necessary partitioning of said trellis is produced such that, for each partitioning step, a set $\Gamma_\infty$ is multiplied by at least one element $\beta$ from the set $B_k$ ($k \geq 1$) of elements of the ring Az such that:

$$B_k = \left\{ X \in Az \ and \ |Det(X)|^2 = 2^k \right\},$$

the set $\Gamma_\infty$ termed "infinite Golden Code" being a principal ideal of the ring Az as defined by the Golden Code technique.

2. Method according to claim 1, **characterized in that** $\beta$ is multiplied to the left of $\Gamma_\infty$.

3. Method according to claim 1, **characterized in that** $\beta$ is multiplied to the right of $\Gamma_\infty$.

4. Method according to any one of the preceding claims, **characterized in that** each component of a partition thus created is indexed by 2k bits of convolutive coding.

5. Method according to any one of claims 1 to 4, **characterized in that** when:

$$\beta = \begin{bmatrix} i(1-\theta) & i(2-\theta) \\ -(2-\bar{\theta}) & i(1-\bar{\theta}) \end{bmatrix}$$

is considered, $\beta$ is an element of $B_1$ , $\theta = \dfrac{1+\sqrt{5}}{2}$ and $\bar{\theta} = \dfrac{1-\sqrt{5}}{2}$ .

6. Method according to any one of claims 1 to 4, **characterized in that** the set $\Gamma_\infty$ is multiplied by an element $\beta'$ such that:

$$\beta' = \begin{bmatrix} i\theta & -(1-\theta) \\ -i(1-\bar{\theta}) & i\bar{\theta} \end{bmatrix},$$

where $\beta'$ is an element of $B_1$.

7. Method according to any one of the preceding claims, with k = 1, **characterized in that** when a partitioning in four steps is carried out, eight bits $c_0$ to $c_7$ are used to carry out the convolutive coding, and these convolutive coding bits are coded from four information bits $b_0$ to $b_3$ such that:

$$c_0 = c_1 = c_2 = 0$$

$$c_3 = xb_0 + x^2 b_1 + x^3 b_2 + x^4 b_3$$

$c_4$, $c_5$, $c_6$ and $c_7$ being respectively equal to one of the bits $b_0$ to $b_3$.

8. System of convolutive coding for the implementation of a method according to any one of the preceding claims, for the transmission of space-time block codes according to the technique termed Golden Code, in a wireless communication network comprising at least a plurality of transmit antennas; **characterized in that** it comprises a convolutive coder (2) receiving information bits to be transmitted and generating a set of coded bits, a space-time block coder (3) of the Golden Code type, these two coders being implemented such that the space-time block coder of the Golden Code type transmits sequences obeying the following conditions: a convolutive coding by trellis coded modulation TCM, and a partitioning necessary to said trellis such that, for each partitioning step, a set $\Gamma_\infty$ is multiplied by at least one element $\beta$ from the set $B_k$ ($k \geq 1$) of elements from the ring Az such that:

$$B_k = \{ \, X \in Az \; and \; |Det(X)|^2 = 2^k \, \},$$

the set $\Gamma_\infty$, termed "infinite Golden Code", being a principal ideal of the ring Az as defined by the Golden Code technique.

## Patentansprüche

1. Verfahren zur konvolutiven Kodierung für die Übertragung von raumzeitlichen Kodes in Blöcken nach der sogenannten Golden-Code-Technik in einem drahtlosen Kommunikationsnetz, umfassend mindestens eine Mehrzahl von Antennen bei der Sendung, **dadurch gekennzeichnet, dass** die Golden-Code-Kodierung mit einer Gitterkodierten Modulation TCM kombiniert ist und dass man die für das Gitter erforderliche Aufteilung so vornimmt, dass man bei jedem Aufteilungsschritt eine Einheit $\Gamma_\infty$ mit mindestens einem Element $\beta$ der Einheit $B_k$ ($k \geq 1$) von solchen Elementen des Rings Az multipliziert, dass

$$B_k = \{ \, X \in Az$$

und

$$|Det(X)|^2 = 2^k \},$$

wobei die Einheit $\Gamma_\infty$, Golden Code unendlich genannt, ein Hauptideal des Rings Az ist, wie er durch die Golden-Code-Technik definiert ist.

2. Verfahren nach Anspruch 1, **dadurch gekennzeichnet, dass** man $\beta$ links von $\Gamma_\infty$ multipliziert.

3. Verfahren nach Anspruch 1, **dadurch gekennzeichnet, dass** man $\beta$ rechts von $\Gamma_\infty$ multipliziert.

4. Verfahren nach einem der vorhergehenden Ansprüche, **dadurch gekennzeichnet, dass** jede Komponente einer auf diese Weise erzeugten Aufteilung mit 2k Bits zur konvolutiven Kodierung indexiert wird.

5. Verfahren nach einem der Ansprüche 1 bis 4, **dadurch gekennzeichnet, dass** gilt:

$$\beta = \begin{bmatrix} i(1-\theta) & i(2-\theta) \\ -(2-\bar\theta) & i(1-\bar\theta) \end{bmatrix},$$

$\beta$ ist ein Element von $B_1$,

$$\theta = \frac{1+\sqrt{5}}{2}$$

und

$$\bar{\theta} = \frac{1-\sqrt{5}}{2}$$

**6.** Verfahren nach einem der Ansprüche 1 bis 4, **dadurch gekennzeichnet, dass** man die Einheit $\Gamma_\infty$ mit einem solchen Element β' multipliziert, dass:

$$\beta' = \begin{bmatrix} i\theta & -(1-\theta) \\ -i(1-\bar{\theta}) & i\bar{\theta} \end{bmatrix},$$

β' ist ein Element von $B_1$.

**7.** Verfahren nach einem der vorhergehenden Ansprüche mit k=1, **dadurch gekennzeichnet, dass** man eine Aufteilung in vier Schritten vornimmt, man acht Bits $c_0$ bis $c_7$ zur Durchführung der konvolutiven Kodierung verwendet und man diese Bits zur konvolutiven Kodierung ausgehend von vier Informationsbits $b_0$ bis $b_3$ kodiert, so dass:

$$c_0 = c_1 = c_2 = 0$$

$$c_3 = x\,b_0 + x^2 b_1 + x^3 b_2 + x^4 b_3$$

wobei $c_4$, $c_5$, $c_6$ bzw. $c_7$ jeweils gleich einem der Bits $b_0$ bis $b_3$ ist.

**8.** System zur konvolutiven Kodierung für die Durchführung eines Verfahrens nach einem der vorhergehenden Ansprüche für die Übertragung von raumzeitlichen Kodes nach der sogenannten Golden-Code-Technik in einem drahtlosen Kommunikationsnetz, das mindestens eine Mehrzahl von Antennen bei der Sendung umfasst, **dadurch gekennzeichnet, dass** es einen konvolutiven Kodierer (2), der zu übertragende Informationsbits empfängt und eine Einheit von kodierten Bits erzeugt, einen raumzeitlichen Kodierer in Blöcken vom Typ Golden Code (3) umfasst, wobei diese beiden Kodierer so implementiert sind, dass der raumzeitliche Kodierer in Blöcken vom Typ Golden Code Sequenzen überträgt, die den folgenden Bedingungen gehorchen: eine konvolutive Kodierung durch Gitterkodierte Modulation TCM und eine solche für das Gitter erforderliche Aufteilung, dass man bei jedem Aufteilungsschritt eine Einheit $\Gamma_\infty$ mit mindestens einem Element β der Einheit $B_k$ (k≥1) von solchen Elementen des Rings Az multipliziert, dass

$$B_k = \{\, X \in Az$$

und

$$|Det(X)|^2 = 2^k \},$$

wobei die Einheit $\Gamma_\infty$, Golden Code unendlich genannt, ein Hauptideal des Rings Az ist, wie er durch die Golden-Code-Technik definiert ist.

FIGURE 1
ART ANTERIEUR

FIGURE 2

Gain de codage

$\Gamma_\infty$ $\qquad$ $1/\sqrt{5}$

$\downarrow$ $c_0\ c_1$

$\beta_1\Gamma_\infty$ $\qquad$ $\sqrt{2}/\sqrt{5}$

$\downarrow$ $c_2\ c_3$

$\beta_1\beta_1{}'\Gamma_\infty$ $\qquad$ $2/\sqrt{5}$

FIGURE 3

Gain de codage

$\Gamma_\infty$ $\qquad$ $1/\sqrt{5}$

$\downarrow$ $c_0\ c_1$

$\beta.\Gamma_\infty$ $\qquad$ $\sqrt{2}/\sqrt{5}$

$\downarrow$ $c_2\ c_3$

$\beta.\Gamma_\infty.\beta'$ $\qquad$ $2/\sqrt{5}$

$\downarrow$ $c_4\ c_5$

$(1{+}i).\beta.\Gamma_\infty$ $\qquad$ $2\sqrt{2}/\sqrt{5}$

$\downarrow$ $c_6\ c_7$

$2.\Gamma_\infty$ $\qquad$ $4/\sqrt{5}$

FIGURE 4

```
0, 16, 32, 48, 64, 80, 96, 112, 128, 144, 160, 176, 192, 208, 224, 240
8, 24, 40, 56, 72, 88, 104, 120, 136, 152, 168, 184, 200, 216, 232, 248
16, 0, 48, 32, 80, 64, 112, 96, 144, 128, 176, 160, 208, 192, 240, 224
24, 8, 56, 40, 88, 72, 120, 104, 152, 136, 184, 268, 216, 200, 248, 232
32, 48, 0, 16, 96, 112, 64, 80, 160, 176, 128, 144, 224, 240, 192, 208
40, 56, 8, 24, 104, 120, 72, 88, 168, 184, 136, 152, 232, 248, 200, 216
48, 32, 16, 0, 112, 96, 80, 64, 176, 160, 144, 128, 240, 224, 208, 192
56, 40, 24, 8, 120, 104, 88, 72, 184, 168, 152, 136, 248, 232, 216, 200
64, 80, 96, 112, 0, 16, 32, 48, 192, 208, 224, 240, 128, 144, 160, 176
72, 88, 104, 120, 8, 24, 40, 56, 200, 216, 232, 248, 136, 152, 168, 184
80, 64, 112, 96, 16, 0, 48, 32, 208, 192, 240, 224, 144, 128, 176, 160
88, 72, 120, 104, 24, 8, 56, 40, 216, 200, 248, 232, 152, 136, 184, 168
96, 112, 64, 80, 32, 48, 0, 16, 224, 240, 192, 208, 160, 176, 128, 144
104, 120, 72, 88, 40, 56, 8, 24, 232, 248, 200, 216, 168, 184, 136, 152
112, 96, 80, 64, 48, 32, 16, 0, 240, 224, 208, 192, 176, 160, 144, 128
120, 104, 88, 72, 56, 40, 24, 8, 248, 232, 216, 200, 184, 168, 152, 136
```

FIGURE 5

FIGURE 6

FIGURE 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **V. Tarokh ; N. Seshadri ; A.R. Calderbank.** Space Time Codes for High Data Rates Wireless Communication : Performance Criterion and Code Construction. *IEEE Transactions on Information Theory,* Mars 1998, vol. 44 (2

- **J. C. Belfiore ; G. Rekaya ; E. Viterbo.** The Golden Code: A 2x2 Full-Rate Space-Time Code with Non-Vanishing Determinants. *IEEE Transactions on Information Theory,* Avril 2005, vol. 44 (2